Europäisches Patentamt

European Patent Office

Office européen des brevets

(19)

(11) Numéro de publication: **0 296 664**
**A1**

## (12) DEMANDE DE BREVET EUROPEEN

(21) Numéro de dépôt: **88201199.2**

(22) Date de dépôt: **10.06.88**

(51) Int. Cl.⁴: **H03M 13/00**

(30) Priorité: **16.06.87 FR 8708370**

(43) Date de publication de la demande:
**28.12.88 Bulletin 88/52**

(84) Etats contractants désignés:
**DE FR GB IT**

(71) Demandeur: **S.A. La Radiotechnique
Industrielle et Commerciale
51 Rue Carnot
F-92150 Suresnes(FR)**

(84) **FR**

(71) Demandeur: **N.V. Philips'
Gloeilampenfabrieken
Groenewoudseweg 1
NL-5621 BA Eindhoven(NL)**

(84) **DE GB IT**

(72) Inventeur: **Pellerin, Daniel
Société Civile S.P.I.D. 209, rue de l'Université
F-75007 Paris(FR)**

(74) Mandataire: **Caron, Jean et al
SOCIETE CIVILE S.P.I.D. 209, rue de
l'Université
F-75007 Paris(FR)**

(54) **Procédé et dispositif de correction d'erreurs dans les données numériques d'un signal de télévision.**

(57) Les signaux numériques sont des codes de Golay à 23 bits constitués de deux parties : un message et une redondance. S'il y a entre zéro et trois erreurs, il y a 2048 cas d'erreur possibles, dont l'examen un à un serait trop long et/ou trop coûteux en mémoire. Mais, s'il y a trois erreurs il y en a soit trois dans une des parties et zéro dans l'autre, soit deux dans une des parties, et une dans l'autre. Donc dans un premier cas, une des parties ne comporte pas d'erreur et sert à recréer de toutes pièces l'autre partie (1-8).

Dans l'autre cas une des parties ne comporte qu'une erreur : on part de cette partie, on en modifie tour à tour (9, 12) les différents bits susceptibles d'être affectées par l'erreur unique, et on vérifie à chaque fois (10,13,15) si l'autre partie pourrait correspondre à la partie modifiée. Le nombre total d'essais est ainsi très limité.

FIG.5

## Procédé et dispositif de correction d'erreurs dans les données numériques d'un signal de télévision.

La présente invention concerne un procédé pour corriger, dans un récepteur de télévision, des erreurs, en nombre inférieur à quatre, dans des données numériques reçues avec le signal de télévision.

Le procédé selon l'invention s'applique notamment au cas de récepteurs dans un système MAC.

Les données numériques sont ici émises selon un codage particulier : elles sont obtenues à l'émission en déterminant par calcul à partir de chaque message à transmettre qui comporte ici 12 bits un mot associé dit "de redondance" qui lui correspond et qui est transmis avec lui. Le mot de redondance comporte ici 11 bits. En outre un mode de calcul particulier est utilisé, où le mot de 11 bits est le reste de la division euclidienne du message par un mot appelé polynome générateur, qui fournit un code dit "de Golay", muni de propriétés remarquables qui rendent avantageux son emploi dans un tel système : le code est cyclique, c'est-à-dire que toute permutation circulaire appliquée aux bits d'un code complet choisi dans l'ensemble des codes fournit un nouveau code qui est encore un élément de l'ensemble. En outre le code est tel que pour deux messages différant l'un de l'autre par un seul bit, les redondances obtenues diffèrent toujours par plus de deux bits, c'est-à-dire que deux codes complets pour deux messages distincts diffèrent toujours l'un de l'autre par plus de trois bits.

A la réception, on commence par établir à partir du code, tel que reçu, un mot particulier appelé syndrome, qui représente la différence entre la redondance telle que reçue et celle qui devrait correspondre au message reçu.

La théorie des codes de Golay enseigne que, à la seule condition que la transmission n'ait pas introduit plus de trois erreurs, on peut toujours retrouver le message initial, et qu'en outre, si le syndrome ne comporte pas plus de trois bits, c'est que les erreurs sont toutes dans la redondance, auquel cas aucune correction n'est nécessaire sur le message.

Mais il arrive que les erreurs soient réparties entre le message et la redondance. Dans ce cas, le syndrome comporte plus de trois bits. Alors plusieurs tactiques peuvent être utilisées. On peut se contenter de noter que le message est erroné et attendre qu'il soit répété ultérieurement, le cas échéant on peut aussi examiner tous les cas possibles de répartition de 1 bit d'erreur dans les 23 bits du code, ce qui représente 23 cas, puis tous les cas avec 2 bits d'erreur soit (23x22)/2 cas, puis tous les cas avec 3 bits d'erreur, soit (23x22x21)-/(3x2) cas, soit au total 2048 cas, en comptant le cas où il n'y a pas d'erreur, et les essayer systématiquement un par un jusqu'à trouver le bon. Mais un tel traitement qui doit être réalisé à la vitesse d'arrivée des codes, requiert une puissance de calcul importante.

L'invention a pour objet de fournir un procédé de correction d'erreur qui corrige exhaustivement tous les cas d'erreurs corrigeables et est néanmois rapide et peu coûteux en capacité de mémoire, et un dispositif pour la mise en oeuvre de ce procédé.

Le procédé selon l'invention est notamment remarquable en ce que, si le syndrome comporte plus de trois bits à 1, on procède à une série d'opérations, dont chacune peut apporter la solution, auquel cas on ne procède pas aux suivantes, et qui consistent en les essais suivants :

- à partir du mot de redondance reçu pour lequel il existe deux messages correspondants capables de former avec lui un code correct, on recherche, pour chacun des deux mots de message correspondants s'il diffère par au plus trois bits du mot de message reçu auquel cas ce mot correspondant est le bon,

- on modifie un par un chacun des douze bits du mot de message reçu et à chaque fois on recherche si le syndrome du code complet reçu muni du message modifié comporte au plus deux bits, auquel cas le mot de message reçu modifié est le bon,

- on modifie un par un chacun des bits du mot de redondance reçu, et on recherche à chaque fois, pour chacun des deux mots de message correspondants, s'il diffère par au plus deux bits du mot de message reçu, auquel cas ce mot de message correspondant est le bon.

Un dispositif avantageux pour la mise en oeuvre de l'invention comporte, pour le calcul du syndrome, un registre à décalage ou un dispositif numérique équivalent, avec un rebouclage depuis la sortie sur les positions du registre correspondant aux termes présents dans le polynome générateur, le rebouclage ayant pour effet de placer dans lesdites positions le résultat de l'addition en "OU EXCLUSIF" du bit sortant avec le bit initialement présent à ladite position.

Pour rechercher si un mot de message correspond à un mot de redondance, le dispositif comporte en outre avantageusement un registre à décalage ou un dispositif numérique équivalent, avec un rebouclage sur les positions de bits correspondant au nombre hexadécimal 49F.

Pour le calcul des syndromes de la série des mots de message modifiés, le dispositif comporte également une mémoire où sont enregistrés des mots correspondant chacun à une colonne d'une matrice générant la redondance à partir du message, et un dispositif pour ajouter tour à tour chacun desdits mots au contenu du registre à décalage, et, pour rechercher si un mot de message correspond à l'un ou l'autre de la série des mots de redondance modifiés, il comporte une autre mémoire où sont enregistrés des mots correspondant chacun à une colonne d'une matrice générant le message à partir de la redondance, et un dispositif pour ajouter tour à tour chacun desdits mots au contenu du registre à décalage.

La description qui va suivre, en regard des dessins annexés décrivant des exemples non limitatifs fera bien comprendre comment l'invention peut être réalisée.

La figure 1 représente une matrice qui peut être utilisée pour le calcul du syndrome.

La figure 2 représente un registre à décalage rebouclé qui réalise une division logique utilisable pour le calcul du syndrome.

La figure 3 représente une autre matrice utilisable dans le procédé.

La figure 4 représente un autre registre à décalage rebouclé utilisable dans le procédé.

La figure 5 est un diagramme illustrant l'ensemble du procédé.

Le procédé basé sur le code de Golay ne permet la correction d'erreurs que pour au plus trois erreurs. Il faut donc remarquer qu'on peut être en présence de trois situations à l'issue du procédé :

- soit on a trouvé les erreurs, et le message reconstitué est correct,
- soit aucun des tests impliqués par le procédé n'a été satisfait : on sait qu'on ne peut pas retrouver le message.
- soit enfin on a cru trouver un message correct, mais en fait il y avait plus de 3 erreurs et le message est en réalité faux : il n'y a malheureusement pas moyen de savoir si l'on est dans ce cas, et le procédé ne serait donc plus utilisable dans des conditions très sévères, mais heureusement rares, ou le rapport signal/bruit serait tel qu'il y ait une probabilité sérieuse d'avoir plus de 3 erreurs par message. Il faut noter que dans de telles conditions, l'ensemble du système serait de toutes façons inutilisable !

Le code de Golay à 23 bits est constitué d'un message de 12 bits et d'une redondance de 11 bits.

Pour définir les opérations à réaliser sur ces séquences de bits, il est commode d'utiliser une représentation mathématique que l'homme du métier comprend comme se rapportant au moyen technique permettant d'exécuter les fonctions spécifiées.

On appelle "m(x)" un polynome représentant le message par a, b, c, d, e, f, g, h, i, j, k, l, m, (chaque terme a, b...m valant 1 ou 0) :
$$m(x) = a x^{11} = b x^{10} + \ldots\ldots + l x + m \text{ (12 termes)}$$

Un tel polynome représente en pratique un mot dans lequel chaque bit dont le rang correspond à une puissance de x a pour valeur celle du coefficient (a, b...m) qui est associé dans le polynome à cette puissance de x.

On appelle "r(x)" un polynome représentant la redondance par p, q, r, s, t, u, v, w, x, y, z :
$$r(x) = p x^{10} + q x^{9} + \ldots\ldots + y x + z. \text{ (11 termes)}$$

Le mode de calcul de la redondance à partir du message est défini au moyen de la relation suivante :
$$m(x) * x^{11} + r(x) = G(x) * q(x) \qquad (1)$$
où G(x) est un polynome générateur. Dans le cas présent, ce polynome est un polynome premier diviseur de $x^{23} + 1$ :
$$G(x) = x^{11} + x^{10} + x^6 + x^5 + x^4 + x^2 + 1$$
Cette relation montre que r(x) peut être considéré comme le reste de la division euclidienne de $m(x)^* x^{11}$ par G(x), division dans laquelle on ne prend pas en compte les retenues (les additions ou soustractions de bits sont toujours ici des "OU EXCLUSIF" et les multiplications des "ET" logiques) et q(x) est le quotient.

Au lieu de considérer des polynomes, on peut fournir une définition équivalente à l'aide d'une méthode matricielle (on utilise soit la méthode par division de polynomes soit la méthode matricielle selon les étapes du processus, ainsi qu'il sera expliqué plus loin).

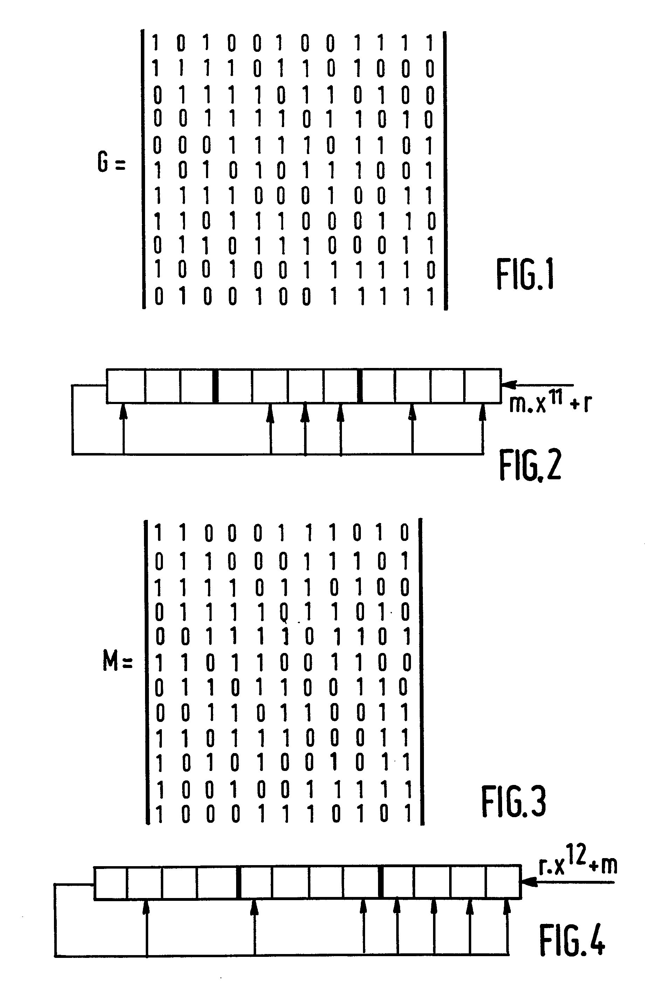

Le message m et la redondance r étant considérés comme des vecteurs :
$$m = (a, b, c, \ldots\ldots l, m)$$
$$r = (p, q, r, \ldots y, z)$$
On obtient alors r à partir de m par la relation :
$$r = G * m$$
où G est la matrice représentée par la figure 1. Le $n^{ième}$ bit de r est ainsi le produit scalaire de la $n^{ième}$ ligne de G par m. Les opérateurs qui correspondent, dans le produit, aux multiplications et additions sont respectivement des fonctions "ET" et "OU exclusif".

A la réception d'un code m, r on peut calculer le SYNDROME s(m,r) du code par :
$$s(m,r) = G^*m + r$$
où G est la matrice de la figure 1.

Le syndrome, résultant de l'addition (OU exclusif) bit à bit de deux termes de 11 bits chacun, est lui aussi un mot de 11 bits. Il représente la différence entre la redondance qui devrait normalement être associée au message tel que reçu, et la redondance réellement reçue. Il est clair que s'il n'y a aucune erreur, cette différence est nulle.

Si, au message m(x), avec sa redondance r(x), sont ajoutées des erreurs que l'on peut représenter par m'(x) et r'(x), le code reçu étant donc m + m' associé à r + r', le syndrome calculé à partir du code reçu sera :

$$s(m+m', r+r') = G^*(m+m') +r+r'$$
$$= G^*m + r + G^*m' + r'$$

dans cette expression $G^*m + r$ est nul, donc le syndrome du code reçu est :

$$s(m+m', r+r') = G^*m' + r' \qquad (3)$$

c'est à dire le syndrome des bits d'erreur qui sont venus s'ajouter au code.

Une propriété des codes de Golay est que si $m'$ n'est pas nul, $G^*m'$ contient plus de trois bits à 1. Donc réciproquement si le syndrome contient moins de trois bits à 1 c'est que $m' = 0$ et que tous les bits d'erreur sont dans $r'$.

Dans les autre cas, qui nous intéressent ici, et où il y a des erreurs dans m, le syndrome contient 4 bits à "1" ou plus, même s'il n'y a qu'une erreur, mais située dans le message m.

On ne sait pas combien il y a d'erreurs, mais on fait l'hypothèse, à priori, qu'il y en a au plus trois : c'est la condition de validité du procédé décrit ci-après.

Lorsqu'il y a au moins une et au plus trois erreurs, on peut distinguer quatre situations possibles :

    A - pas d'erreur dans le message et une à trois erreurs dans la redondance

    B - une à trois erreurs dans le message, et aucune dans la redondance

    C - une erreur dans le message, et une ou deux erreurs dans la redondance

    D - une ou deux erreurs dans le message, et seulement une erreur dans la redondance.

Le cas A a déjà été mentionné plus haut, il ne pose pas de problème, le message est bon.

Dans le cas B, puisqu'il n'y a pas d'erreur dans la redondance, on peut essayer de recréer le message m à partir de la redondance r.

L'exposé qui suit explique comment on peut calculer un message correspondant à une redondance donnée :

A partir de l'expression (1), multiplions de part et d'autre par $x^{12}$:

$$m(x)^*x^{23} + r(x)^*x^{12} = G(x)^*x^{12}{}^*q(x)$$

le code étant cyclique, le premier terme de cette relation est équivalent à :

$$r(x)^*x^{12} + m(x)$$

Ce terme étant donc un code de Golay, il est divisible par un polynome P(x) de degré 12 diviseur de $x^{23}+1$ :

$$r(x)^*x^{12} + m(x) = P(x)^*Q_2(x) = G(x)^*x^{12}{}^*q(x) \qquad (4)$$

Les diviseurs premiers de $x^{23} + 1$ sont :

$$x + 1$$
$$x^{11} + x^{10} + x^6 + x^5 x^4 + x^2 + I = G(x)$$
$$x^{11} + x^9 + x^7 + x^6 + x^5 + x + 1 = H(x)$$

Il y a donc deux possibilités : P(x) est soit égal à $(x+1)^*G(x)$, soit égal à $(x+1)^*H(x)$. Pour satisfaire la deuxième égalité de (4), il faut que G(x) divise soit P(x) soit $Q_2(x)$. Si $P(x) = (x+1)^*H(x)$, il ne peut être divisé par G(x). Donc G(x) divise $Q_2(x)$ et on a $Q_2(x) = G(x)^*Q_3(x)$. L'égalité (4) devient donc, en remplaçant $Q_2(x)$ et P(x) par leurs valeurs :

$$r(x)^*x^{12} + m(x) = H(x)^*(x+1)^*G(x)^*Q_3(x):$$

Ce qui est impossible, car $H(x)^*(x+1)^*G(x) = x^{23}+1 = 0$

($x^{23}$ est équivalent à 1 puisque le produit par $x^{23}$ correspond à une permutation circulaire complète, donc $x^{23}+1 = 1+1 = 0$, le signe + signifiant toujours "OU exclusif")

Donc : $P(x) = (x+1)^*G(x)$

    et $r(x)^* x^{12} + m(x) = (x+1)^*G(x)^*Q_2(x)$

On peut donc obtenir le message à partir de la redondance d'une manière analogue à celle utilisée pour obtenir la redondance à partir du message, le polynome impliqué étant alors $(x+1).G(x)$.

Comme la redondance comporte un bit de moins que le message, on peut s'attendre à ce qu'il existe deux messages différents qui lui correspondent tous deux. Si, à l'expression (1), on ajoute de chaque côté $G(x)^*x^{11}$, il vient :

$$[m(x) + G(x)] x^{11} + r(x) = G(x) [q(x) + x^{11}]$$

donc si m(x) est un message correspondant à la redondance r(x), l'autre message correspondant est m(x) + G(x) puisqu'il donne le même reste lors de sa division par G(x). Dans la notation habituelle en informatique, le polynome G(x) représente un mot de 12 bits dont la valeur en hexadécimal est C75.

Pour la reconstitution du message on peut utiliser aussi une méthode matricielle. On parvient à déterminer une matrice, spécifique pour le procédé de l'invention, qui permet de retrouver les messages correspondant à différentes redondances. C'est la matrice M de la figure 3 .

On obtiendra le message m correspondant en calculant :

$$m = M ^* r \qquad (5)$$

Comme on suppose qu'il y a au plus trois erreurs et qu'elles sont toutes dans le message, le message reconstitué m correspondant à la redondance reçue ne doit pas différer par plus de trois bits du message reçu erroné, sinon on essaie l'autre message correspondant à la redondance, c'est à dire m + C75. Si l'un des deux messages reconstitués répond à cette condition, c'est le message cherché.

Dans le cas C, il n'y a qu'une erreur dans le message. Cette erreur porte donc sur un et un seul des douze bits du message. Il y a donc seulement douze cas possibles. On modifie, en le complémentant à un, tour à tour chaque bit du message reçu, et à chaque fois on applique un test pour savoir si on a obtenu le bon message. Le code avec un bit modifié pour essai sera nommé "code corrigé".

Si effectivement on a recréé le bon message, le syndrome du code corrigé est $r'$ (dans l'expression (3) plus haut, $m'$ est nul si le message est corrigé). Comme, dans le cas C, il y a deux erreurs au plus dans la redondance, ce syndrome égal à $r'$ comportera donc au plus deux bits à 1. Si on n'a pas recréé le bon message, le produit $G^*m'$ contient plus de trois bits à 1 ainsi qu'il a déjà été indiqué, et le syndrome contient donc plus de trois bits à 1.

En conclusion pour le cas C : si le syndrome du code corrigé comporte au plus 2 bits à 1, c'est que le message modifié est bon.

Le cas D est traité comme une combinaison des cas B et C : s'il n'y a qu'une erreur dans la redondance, qui comporte onze bits, il y a donc onze cas possibles. On modifie donc, par complémentation à un, tour à tour, chaque bit de la redondance reçue. Si dans l'un de ces onze cas, le code corrigé comporte une redondance modifiée qui ne contient pas d'erreur, alors on est dans le cas B, que l'on traite comme tel. Néanmoins, dans le présent cas D, il y a au plus deux erreurs dans le message (et non plus trois comme dans le cas B), et le critère déterminant la validité de chacun des deux messages correspondant à chaque redondance modifiée consiste en sa différence d'au plus deux bits par rapport au message reçu.

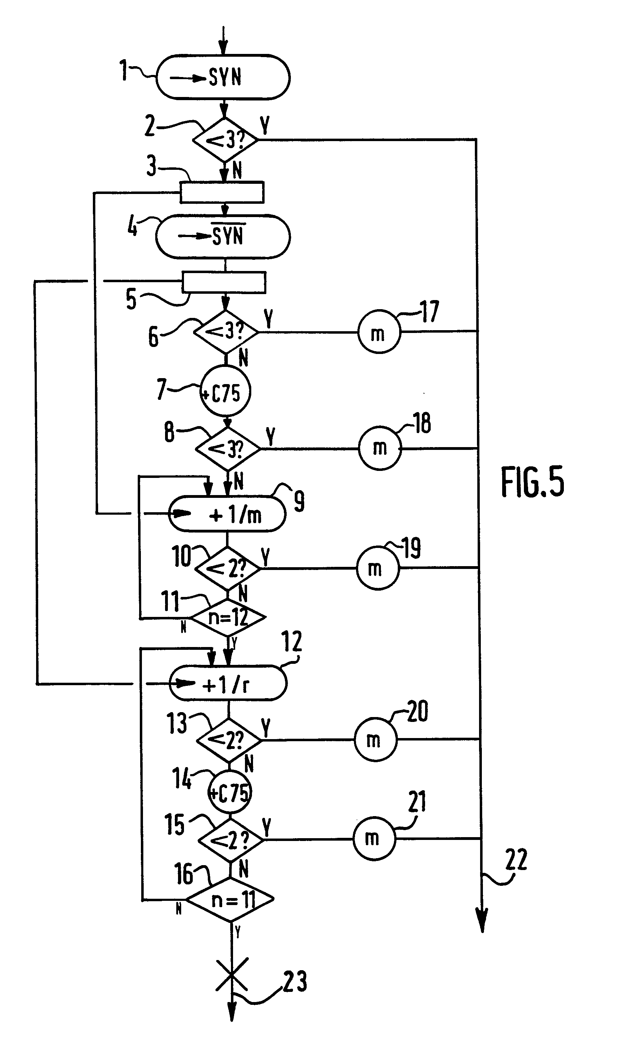

La figure 5 rassemble l'ensemble des étapes du processus décrit ci-dessus. Le code reçu est introduit en haut de la figure dans un module 1 qui représente le calcul du syndrome. Ce syndrome est utilisé dans l'étape 2 où l'on teste le nombre de ses bits à 1. Si ce nombre est inférieur à 3, condition notée Y, le message reçu est correct et le processus est terminé. On en sort par la flèche 22. Si le syndrome a plus de trois bits à 1, la condition notée N est obtenue et le syndrome est mémorisé dans l'étape 3 pour éventuellement resservir dans l'étape 9. L'étape 4 correspond à la reconstitution du message à partir de la redondance. En pratique, comme on le verra plus loin, on ne calcule pas le message lui-même, mais la différence entre le message correspondant à la redondance et le message réellement reçu. Cette différence est appelée "syndrome inverse".

Ce syndrome inverse est mémorisé dans l'étape 5 pour éventuellement resservir dans l'étape 12. Dans l'étape 6 on teste si le syndrome inverse comporte moins de trois bits à 1, c'est-à-dire si le message reconstitué diffère par moins de trois bits du message reçu. Si ceci est vérifié (condition Y) le syndrome inverse est ajouté au message reçu, dans l'étape 17, et le processus est terminé. Si ce n'est pas vérifié (condition N) on arrive à l'étape 7 où on ajoute C75 (hexadécimal) au syndrome inverse puis on réalise en 8,18 les mêmes opérations qu'en 6,17. Si la condition 8 n'est pas réalisée on aboutit à l'étape 9 o l'on calcule le syndrome avec complémentation à 1 du premier bit du message, et l'on vérifie dans l'étape 10 s'il a au plus deux bits à 1. Si la condition est remplie, on complémente le premier bit du message dans l'étape 19, sinon on teste en 11 quel numéro de bit a été modifié, et si on n'est pas encore arrivé au douzième bit, on remonte en 9 où l'on calcule le syndrome avec complémentation du bit suivant du message et ainsi de suite jusqu'au douzième bit du message. Si on n'a toujours pas trouvé de bon message et qu'on est arrivé au douzième bit, on aboutit à l'étape 12, ou l'on modifie le premier bit de la redondance. Pour calculer plus facilement le message à partir de la redondance on réutilise le "syndrome inverse" de l'étape 5, d'une manière qui sera expliquée plus loin, pour en déduire le syndrome inverse du code muni de la redondance modifiée (qu'on appelera syndrome inverse modifié), et l'on teste alors dans l'étape 13 si ce syndrome inverse modifié comporte moins de 2 bits à 1, auquel cas on l'ajoute dans l'étape 20 au message et le processus est terminé. Si ce n'est pas le cas, on ajoute C75 au syndrome inverse modifié et on arrive aux opérations 15, 21 identiques aux opérations 13, 20. Si aucun des deux syndromes inverses modifiés ne convient, on teste en 16 le numéro du bit modifié (de façon analogue à l'étape 11) et on retourne en 12 s'il reste des bits à modifier. Si on arrive au 11e bit inclus sans trouver de message satisfaisant, on sort par la flèche 23 qui indique que l'ensemble du processus a échoué.

Il est clair que ce processus comporte des groupes d'étapes indépendants les uns des autres et que ces groupes peuvent être intervertis : les groupes respectifs (1-2), (4-8), (9-11) et (12-16) peuvent en principe être placés dans n'importe quel ordre. En pratique il est plus commode de commencer par les tests les plus simples, d'où l'ordre indiqué.

Un dispositif pour la mise en oeuvre du processus va être décrit maintenant. En pratique les divisions de polynomes sont réalisées au moyen de registres à décalage rebouclés. La figure 2 représente un registre, comportant 11 positions et dont la sortie est rebouclée en même temps sur les positions 0, 2, 4, 5, 6, 10, le rebouclage ayant pour effet de placer dans lesdites positions de mémoire le résultat de l'addition en "OU EXCLUSIF" du bit sortant avec le bit initialement présent à ladite position. On remarquera que ces positions correspondent chacune à une puissance de x dans le polynôme générateur $G(x)$, le terme le plus à gauche ($x^{11}$) étant omis. En d'autres termes, à chaque fois qu'un bit sort à gauche du registre, on ajoute 475 (hexadécimal) au registre.

On sait qu'un tel montage réalise la division d'un premier nombre $m^*x^{11} + r$ introduit dans le registre, par un deuxième nombre qui est représenté par des bits à 1 aux positions de rebouclage, plus un bit à gauche : ici on divise donc par le nombre qui correspond au polynome générateur G-(x). Le contenu final du registre correspond au reste de la division. Si l'on introduit dans le registre un message erroné, le contenu final est le reste correspondant à ce message erroné, c'est à dire la redondance qui devrait lui être associée. Comme on introduit à la suite du message la redondance telle que reçue, ces deux valeurs sont ajoutées l'une à l'autre ce qui correspond à la définition du syndrome. A la fin de l'opération, c'est donc le syndrome du code qui est présent dans ce registre.

Bien entendu il est possible soit d'utiliser effectivement un registre à décalage matériel, soit de simuler l'action de ce registre au moyen d'un logiciel associé à une unité de calcul.

Le dispositif comporte donc un registre à décalage, ou un dispositif numérique équivalent, avec un rebouclage depuis la sortie sur les positions du registre correspondant aux termes présents dans le polynome générateur, qui permet de calculer le syndrome. On compte alors de façon connue le nombre de bits à 1 présents dans le syndrome et si ce nombre est inférieur à trois, alors il n'y a pas d'erreur dans le message reçu.

Si ce n'est pas le cas, on passe au cas B mentionné plus haut, et on calcule le syndrome inverse à l'aide d'un deuxième registre à décalage, matériel ou simulé, basé sur le même principe, et représenté par la figure 4, dont la sortie est rebouclée sur les positions de bits correspondant au nombre hexadécimal 49F, et qui comporte douze positions. On a vu plus haut que le message peut être reconstitué à partir de la redondance au moyen du polynome générateur $(x+1)^*G(x)$, c'est à dire du mot obtenu en multipliant C75 (c'est-à-dire G(x) exprimé en hexadécimal) par le nombre binaire 11 (c'est-à-dire : $x+1$). Le mot obtenu est 149F (en hexadécimal) qui a 13 bits, et de même que dans le cas précédent, on abandonne le bit de gauche, ce qui donne 49F avec 12 bits. On entre alors $r^*x^{12}+m$ dans le registre de 12 bits, c'est-à-dire d'abord la redondance, ce qui entraîne la formation d'un message associé, puis le message reçu, ce qui forme sa différence avec le message associé précédemment formé, c'est-à-dire ce qu'on a appelé plus haut le syndrome inverse : si la redondance est correcte il comporte un nombre de bits à 1 égal au nombre d'erreurs dans le message. On vérifie si ce nombre est inférieur à 3. Si c'est le cas, on ajoute le contenu du registre au message, pour corriger ses erreurs. Sinon on ajoute C75 au syndrome inverse comme on l'a expliqué plus haut pour créer le syndrome inverse du deuxième message qui correspond aussi à la redondance, et on conclut de la même façon.

Si le syndrome comporte encore plus de 3 bits à 1, on passe au cas C. Ici intervient en pratique la méthode matricielle indiquée plus haut, qui permet de reconstituer les mots de message corrigés sans refaire à chaque fois le calcul complet du syndrome inverse pour chaque cas examiné. A partir de la matrice G et de la relation (2) on traite le cas où l'on veut modifier un bit du message. En appelant "e" un mot de correction comportant un seul bit et que l'on ajoute au message pour le corriger, le syndrome correspondant est :

$$s(m,r) = G^*(m+e) + r$$
$$= [G^*m + r] + G^*e$$

A partir de l'expression $G^*m + r$ déjà calculée, il suffit donc d'ajouter $G^*e$ pour obtenir le nouveau syndrome. Comme e ne comporte qu'un bit à 1, le produit matriciel $G^*e$ est égal à la colonne de la matrice dont le rang est égal à celui du bit dans e. Pour obtenir les syndromes correspondants à la correction de chacun des bits tour à tour, il suffira d'ajouter chaque colonne de la matrice G tour à tour au syndrome du code reçu, précédemment calculé, c'est à dire au contenu du registre à décalage de la figure 2 après qu'il ait servi pour le cas A. (bien entendu, il faut le remettre à l'état antérieur avant d'ajouter chaque colonne de matrice suivante). C'est à cet effet que, dans le processus de la figure 5, on avait mémorisé le contenu du registre à l'étape 3. Pour chaque contenu modifié du registre, on compte le nombre de bits à 1, et s'il est inférieur à deux, on ajoute le mot de correction au message pour le corriger, sinon on continue jusqu'au douzième mot de correction.

Si à ce moment on n'a toujours pas obtenu satisfaction, on passe à l'étape D. (qu'on aurait d'ailleurs aussi bien pu traiter avant l'étape C). Pour cette étape, la matrice M est utilisée, de façon analogue à la matrice G dans l'étape C. La validité de la méthode se démontre de façon semblable, en partant de la matrice M et de la relation (5). On additionne donc les unes après les autres les colonnes de la matrice M qui sont mémorisées une fois pour toutes dans une mémoire, au syndrome inverse obtenu dans le registre à décalage de la figure 4 après qu'il ait servi pour le cas B, et que l'on avait mis en mémoire dans l'étape 5 de la figure 5. A chaque fois on compte le nombre de bits à 1 du registre, s'il y en a au plus deux on ajoute ce registre au message, sinon on y ajoute C75 comme dans le cas B, et on compte les bits à 1, et ainsi de suite jusqu'à la onzième colonne de la matrice M.

Si dans aucun des cas on n'arrive à une solution c'est que le message contient plus de trois erreurs.

Le dispositif associé au procédé à l'avantage d'être rapide et aussi d'utiliser peu de mémoire : il utilise seulement quelques dizaines d'octets alors que la mémorisation de toutes les erreurs possibles exigerait 6K octets, à raison de 3 octets de longueur du code, multiplié par les 2048 cas possibles.

**Revendications**

1. Procédé pour corriger, dans un récepteur de télévision, des erreurs, en nombre inférieur à quatre, dans des données numériques reçues avec le signal de télévision et codées selon un code cyclique dit de Golay, comprenant un mot de 12 bits représentant un message, et un mot de 11 bits, qui est le reste de la division euclidienne du message par un mot appelé polynome générateur, et qui assure une redondance, selon lequel on commence par établir à partir du code, tel que reçu, un mot particulier appelé syndrome, qui représente la différence entre la redondance telle que reçue et celle qui devrait correspondre au message reçu, et permet d'affirmer que le message ne contient pas d'erreur si le syndrome comporte au plus trois bits à 1, c'est à dire diffère par au plus trois bits de celui qui serait obtenu en l'absence d'erreur, caractérisé en ce que, si le syndrome comporte plus de trois bits à 1, on procède à une série d'opérations, dont chacune peut apporter la solution, auquel cas on ne procède pas aux suivantes, et qui consistent en les essais suivants :
- à partir du mot de redondance reçu pour lequel il existe deux mots de message correspondants capables de former avec lui un code correct, on recherche pour chacun des deux mots de message correspondants, s'il diffère par au plus trois bits du mot de message reçu, auquel cas ce mot correspondant est le bon,
- on modifie un par un chacun des douze bits du mot de message reçu et à chaque fois on recherche si le syndrome du code complet reçu, muni du message modifié, comporte au plus deux bits à 1, auquel cas le mot de message reçu modifié est le bon,
- on modifie un par un chacun des bits du mot de redondance reçu, et on recherche à chaque fois, pour chacun des deux mots de message correspondants, s'il diffère par au plus deux bits du mot de message reçu, auquel cas ce mot de message correspondant est le bon.

2. Dispositif pour la mise en oeuvre du procédé selon la revendication 1, caractérisé en ce qu'il comporte, pour le calcul du syndrome, un registre à décalage ou un dispositif numérique équivalent, avec un rebouclage depuis la sortie sur les positions du registre correspondant aux termes présents dans le polynome générateur, le rebouclage ayant pour effet de placer dans lesdites positions le résultat de l'addition en "OU exclusif" du bit sortant avec le bit initialement présent à ladite position.

3. Dispositif pour la mise en oeuvre du procédé selon la revendication 1, caractérisé en ce qu'il comporte pour le calcul du syndrome inverse, c'est-à-dire de la différence entre le message qui a été reçu et un message correspondant à la redondance qui a été reçue, un registre à décalage ou un dispositif numérique équivalent, avec un rebouclage sur les positions de bits correspondant au nombre hexadécimal 49F.

4. Dispositif selon la revendication 2, caractérisé en ce qu'il comporte, pour le calcul des syndromes des codes corrigés, une mémoire où sont enregistrés des mots correspondant chacun à une colonne d'une matrice (G) générant la redondance à partir du message, et un dispositif pour ajouter tour à tour chacun desdits mots au contenu du registre à décalage.

5. Dispositif selon la revendication 3, caractérisé en ce qu'il comporte, pour le calcul des syndromes inverses des codes corrigés, une mémoire où sont enregistrés des mots correspondant chacun à une colonne d'une matrice (M) générant le message à partir de la redondance, et un dispositif pour ajouter tour à tour chacun desdits mots au contenu du registre à décalage.

$$G = \begin{vmatrix} 1 & 0 & 1 & 0 & 0 & 1 & 0 & 0 & 1 & 1 & 1 & 1 \\ 1 & 1 & 1 & 1 & 0 & 1 & 1 & 0 & 1 & 0 & 0 & 0 \\ 0 & 1 & 1 & 1 & 1 & 0 & 1 & 1 & 0 & 1 & 0 & 0 \\ 0 & 0 & 1 & 1 & 1 & 1 & 0 & 1 & 1 & 0 & 1 & 0 \\ 0 & 0 & 0 & 1 & 1 & 1 & 1 & 0 & 1 & 1 & 0 & 1 \\ 1 & 0 & 1 & 0 & 1 & 0 & 1 & 1 & 1 & 0 & 0 & 1 \\ 1 & 1 & 1 & 1 & 0 & 0 & 0 & 1 & 0 & 0 & 1 & 1 \\ 1 & 1 & 0 & 1 & 1 & 1 & 0 & 0 & 0 & 1 & 1 & 0 \\ 0 & 1 & 1 & 0 & 1 & 1 & 1 & 0 & 0 & 0 & 1 & 1 \\ 1 & 0 & 0 & 1 & 0 & 0 & 1 & 1 & 1 & 1 & 1 & 0 \\ 0 & 1 & 0 & 0 & 1 & 0 & 0 & 1 & 1 & 1 & 1 & 1 \end{vmatrix}$$

FIG.1

$m \cdot x^{11} + r$

FIG.2

$$M = \begin{vmatrix} 1 & 1 & 0 & 0 & 0 & 1 & 1 & 1 & 0 & 1 & 0 \\ 0 & 1 & 1 & 0 & 0 & 0 & 1 & 1 & 1 & 0 & 1 \\ 1 & 1 & 1 & 1 & 0 & 1 & 1 & 0 & 1 & 0 & 0 \\ 0 & 1 & 1 & 1 & 1 & 0 & 1 & 1 & 0 & 1 & 0 \\ 0 & 0 & 1 & 1 & 1 & 1 & 0 & 1 & 1 & 0 & 1 \\ 1 & 1 & 0 & 1 & 1 & 0 & 0 & 1 & 1 & 0 & 0 \\ 0 & 1 & 1 & 0 & 1 & 1 & 0 & 0 & 1 & 1 & 0 \\ 0 & 0 & 1 & 1 & 0 & 1 & 1 & 0 & 0 & 1 & 1 \\ 1 & 1 & 0 & 1 & 1 & 1 & 0 & 0 & 0 & 1 & 1 \\ 1 & 0 & 1 & 0 & 1 & 0 & 0 & 1 & 0 & 1 & 1 \\ 1 & 0 & 0 & 1 & 0 & 0 & 1 & 1 & 1 & 1 & 1 \\ 1 & 0 & 0 & 0 & 1 & 1 & 1 & 0 & 1 & 0 & 1 \end{vmatrix}$$

FIG.3

$r \cdot x^{12} + m$

FIG.4

FIG.5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-4 414 667 (J.F. BENNETT) <br> * Colonne 1, ligne 14 - colonne 7, ligne 21; figures * <br> --- | 1,2 | H 03 M 13/00 |
| A | IBM TECHNICAL DISCLOSURE BULLETIN, vol. 17, no. 3, août 1974, pages 702-703, New York, US; C.R.P. HARTMANN et al.: "Meggett encoder with simplified combinatorial logic" <br> * En entier; figure * <br> --- | 1 | |
| A | COMPUTER DESIGN, vol. 21, no. 6, juin 1982, pages 121-130, Winchester, Massachusetts, US; L.J. RENNIE: "Forward-looking error correction via extended Golay" <br> --- | | |
| A | US-A-3 622 982 (B. CLARK, Jr. et al.) <br> --- | | |
| A | GLOBECOM '82, IEEE GLOBAL TELECOMMUNICATIONS CONFERENCE, Miami, 29 novembre - 2 décembre 1982, vol. 3, pages 1114-1118; P.L. PATTERSON: "New performance analyses for the Golay and shortened Golay codes" <br> --- | | |
| A | IEEE TRANSACTIONS ON INFORMATION THEORY, vol. IT-10, no. 2, avril 1964, pages 134-138; T. KASAMI: "A decoding procedure for multiple-error-correcting cyclic codes" <br> ----- | | |

**DOMAINES TECHNIQUES RECHERCHES (Int. Cl.4)**

H 03 M
H 04 L
G 06 F
G 11 B

Le présent rapport a été établi pour toutes les revendications

| Lieu de la recherche | Date d'achèvement de la recherche | Examinateur |
|---|---|---|
| LA HAYE | 23-09-1988 | DEVERGRANNE C.A. |

EPO FORM 1503 03.82 (P0402)